# EUROPEAN PATENT APPLICATION

(11) **EP 1 701 383 A1**
(43) Date of publication of application: **13.09.2006**
(21) Application number: 05005272.9
(22) Date of filing: 10.03.2005
(51) Int. Cl.: H01L 23/498, H01L 23/32

(54) **Contact pad adapter for semiconductor package**

(71) Applicant: Optium Care International Tech. Inc., 114 Taipei City (TW)
(72) Inventor: Lien, Jeffrey, Shihlin District Taipei City 111 Taiwan (TW)
(74) Representative: Vossius & Partner

(57) **Abstract**

The present invention is related to a switching media for chip carrier device, the switching media has a flexible board , the flexible board has circuits and a plurality, of connecting points by way of etching thereon, the connecting points are able to connect to any type of chip of integrated circuit electrically, another plurality of etched connecting points on a lower surface of the flexible board are capable of connecting to the chip carrier device electrically, the circuits thereon individually connect to the connecting points on an upper surface of the flexible board and the connecting points on the lower surface. It is convenient for that the flexible board can electrically connect to the chip carrier device while the flexible board is installed on the chip carrier device. Hence, the upper surface is able to be mounted by any type of integrated circuit chip to reach the purposes of any chip connecting to the chip carrier device by means of the flexible board and any chip being changeable anytime.

## Description

### FIELD OF THE INVENTION

The present invention relates to a switching media for chip carrier device, especially to the switching media that being capable of electrically connecting to any type of chip.

### BACKGROUND OF THE INVENTION

Normally suitable package is put on a chip for integrated circuits for anti-pollution or protecting damage due to the fragile character of the chip, and the chip can be properly and electrically connected to a PCB, a carrying board or a lead frame for conducting current.

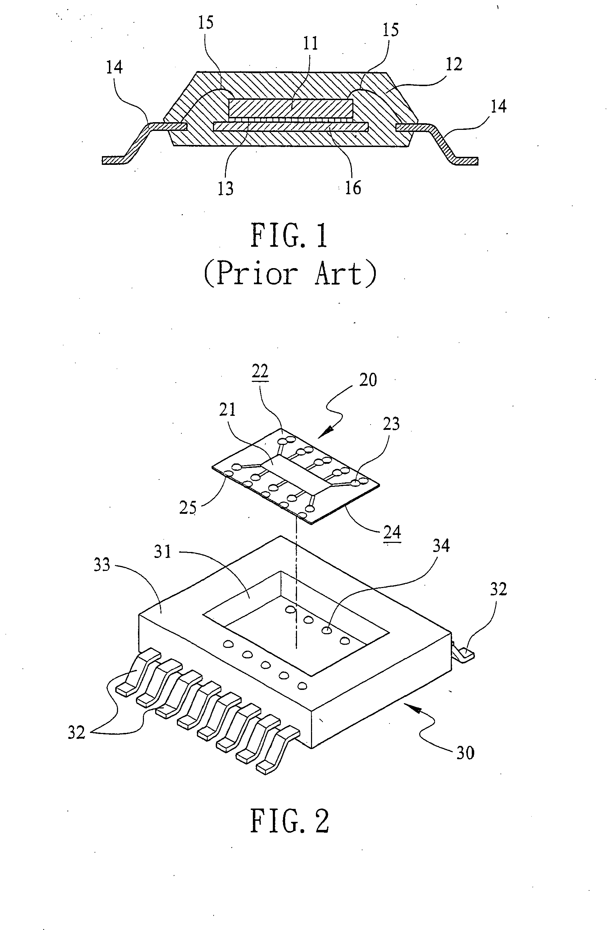

Please refer to Fig. 1, a packing structure for general integrated circuit chip comprises: a chip 11, a packing colloid 12 and a lead frame for conducting current to outside, wherein the lead frame has a chip pad 16 and a plurality of legs 14 , wherein the chip 11 sticks on the chip pad 16 by way of viscose 13 as coagel , a plurality of leading wires 15 connect to both welding pad of the chip 11 and inner ends of the legs 14 inside the packing colloid 12, outer ends of the legs 14 elongate out of the packing colloid 12 for touching with PCB.

However, chip 11, legs 14 and leading wires 15 are as a certain type of assembly in packing colloid 12 after packing integrated circuits, and while the integrated circuits connect to a PCB, the PCB can only fix and use the chip 11. In case of the chip 11 not working properly and being changed or upgraded, the PCB may then be damaged easily.

### SUMMARY OF THE INVENTION

According to the disadvantage of changing integrated circuits in prior arts, the inventor has being developed a new technology of a switching media for chip carrier device depending on the experiences of manufacturing integrated circuits to improve the disadvantage in prior arts.

The primary objective of the present invention is to provide a switching media being capable of making any chip electrically connect to a chip carrier device, the switching media has a flexible board, the flexible board has circuits and a plurality of connecting points by way of etching thereon, the connecting points are able to connect to any type of chip of integrated circuit electrically, another plurality of etched connecting points on a lower surface of the flexible board are capable of connecting to the chip carrier device electrically, the circuits thereon individually connect to the connecting points on an upper surface of the flexible board and the connecting points on the lower surface. It is convenient for that the flexible board can electrically connect to the chip carrier device while the flexible board is installed on the chip carrier device. Hence, the upper surface is able to be mounted by any type of integrated circuit chip to reach the purposes of any chip connecting to the chip carrier device by means of the flexible board and any chip being changeable anytime.

Other and further features, advantages and benefits of the invention will become apparent in the following description taken in conjunction with the following drawings. It is to be understood that the foregoing general description and following detailed description are exemplary and explanatory but are not to be restrictive of the invention. The accompanying drawings are incorporated in and constitute a part of this application and, together with the description, serve to explain the pririciples of the invention in general terms. Like numerals refer to like parts throughout the disclosure.

### BRIEF DESCRIPTION OF THE DRAWINGS

Fig. 1 is a side view of a packing structure of a normal integrated circuit chip in prior arts;
Fig. 2 is a 3-D view of the present invention;
Fig. 3 is a side view of the present invention;
Fig. 4 is a first side view of a chip of the present invention;
Fig. 5 is a second side view of a chip of the present invention;
Fig. 6 is a third side view of a chip of the present invention;
Fig. 7 is a fourth side view of a chip of the present invention.

### DETAILED DESCRIPTION OF THE PREFERRED EMBODIMENTS

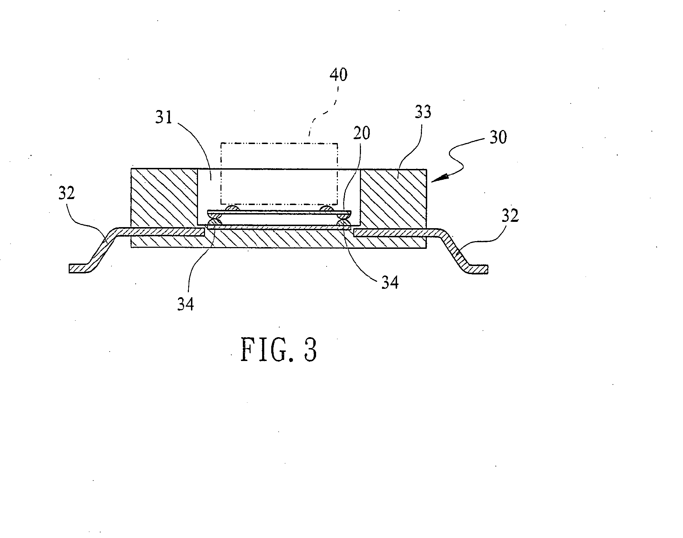

Please refer to Figs. 2 and 3, the present invention is a switching media for chip carrier device, and the switching media comprises a flexible board 20 with an insulating film (the insulating film is a plastic film for the preferred embodiment, but not restricted for practical application), the flexible board 20 has circuits 21, a plurality of etched connecting points 23 electrically connecting to at least one chip 40 (integrated circuit chip) are on an upper surface 22 of the flexible board 20, and another plurality of etched connecting points 25 electrically connecting to a chip carrier device 30 are on a lower surface 24, the circuits 21 individually connect to the connecting points 23 and the connecting points 25 so as to that the circuits 21, the connecting points 23 and the connecting points 25 being related electrically.

Please again refer to Figs. 2 and 3, the flexible board 20 can be put on a carrier base 31 inside the chip carrier device 30 for that the flexible board 20 connecting to the chip carrier device 30 electrically, such that, any or plural types of chips 40 (integrated circuit chip) can be installed on the upper surface 22 of the flexible board 20 so as to that any type of chip 40 being connected to the chip carrier device 30 by the flexible board 20. Therefore, it is obvious that installing any or different type of chip is variable anytime.

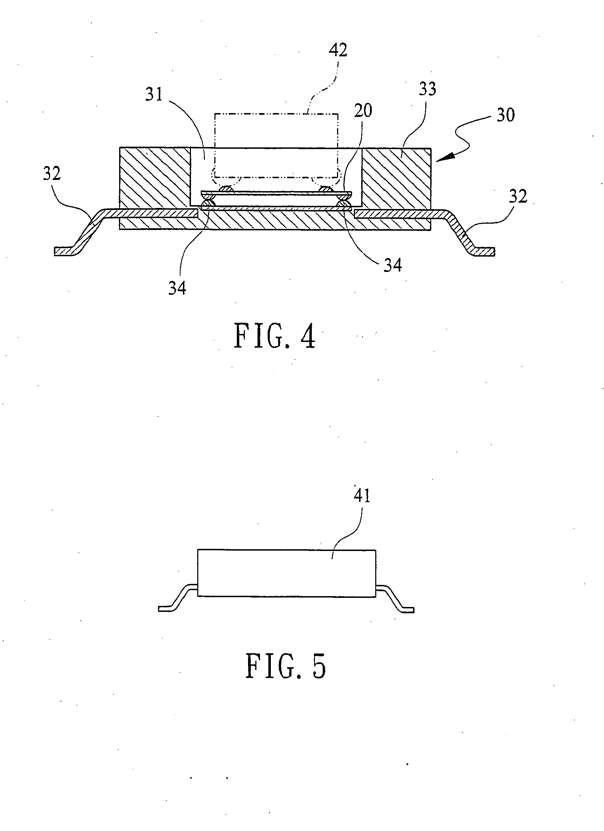

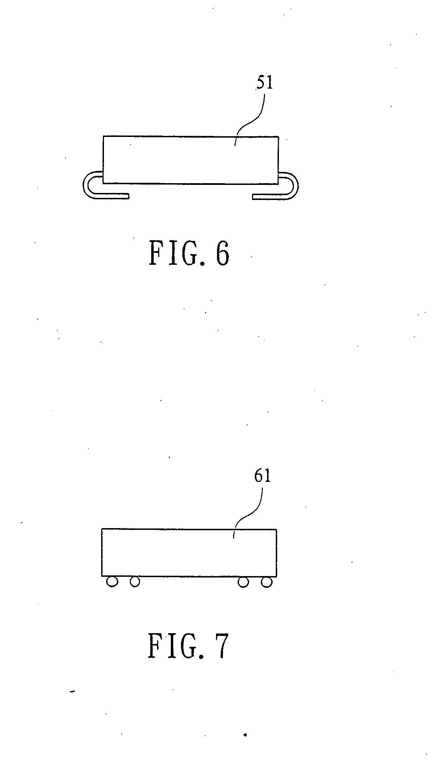

Please refer to Fig. 4, the connecting points 23 can be designed based on legs (not shown in Fig. 4) of a die 42, such as external elongation mode 41 shown in Fig. 5, internal bending mode 51 shown in Fig. 6 and soldering ball mode 61 shown in Fig. 7. Thus, the category of die modes may be increased as preferred embodiments mentioned above.

Back to Figs. 2 and 3, the chip carrier device 30 comprises the opening carrier base 31 and a packing colloid 33, wherein the carrier base 31 has an opening space for reserving different types of chips 40, a plurality of connecting points 34 are set on a surface of the carrier base 31 corresponding to the connecting points 25 so as to that the flexible board 20 connecting to the chip carrier device 30 electrically during the flexible board 20 being installed on the carrier base 31, inner ends of legs 32 are sealed in the packing colloid 33, outer ends of the legs 32 are elongated externally to be as connecting points between the legs 32 and circuits of a PCB for electrical connection of the chip carrier device 30 and the PCB, further that, another electrical connection between the chip 40 and the PCB is successfully made.

Another preferred embodiment of the present invention is that to construct several containing rooms by way of folding the flexible board 20 or using plural flexible boards 20 directly at the moment of the flexible board 20 being mounted on the carrier base 31, each containing room may then be able to reserve a chip for the electrical connection of the flexible board 20 and the chip carrier device 30.

While the invention has been described by way of example and in terms of a preferred embodiment, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures.

## Claims

1. A switching media for chip carrier device comprising:
a flexible board having an insulated film, circuits and a plurality of connecting points by way of etching thereon, the connecting points being able to connect to at least one type of chip of integrated circuit electrically, another plurality of etched connecting points on a lower surface of the flexible board being capable of connecting to the chip carrier device electrically, the circuits thereon individually connect to the connecting points on an upper surface of the flexible board and the connecting points on the lower surface;
wherein the flexible board can electrically connect to the chip carrier device while the flexible board is installed on the chip carrier device, hence, the upper surface is able to be mounted by plural types of integrated circuit chips to reach conditions of any chip connecting to the chip carrier device by means of the flexible board and any chip being changeable anytime.

2. The switching media for chip carrier device as cited in Claim 1, wherein the chip can be made of die.

3. The switching media for chip carrier device as cited in Claim 2, wherein the connecting points on the upper surface of the flexible board can be designed based on legs of different arrangements of different dies and different types of legs to increase a category of die modes.

4. The switching media for chip carrier device as cited in Claim 1, wherein the chip carrier device comprises an opening carrier base, plural connecting points and a packing colloid, wherein the carrier base has an opening space for reserving different types of chips, the connecting points are set on a surface of the carrier base corresponding to the connecting points on the lower surface so as to that the flexible board connecting to the chip carrier device electrically during the flexible board being installed on the carrier base.

5. The switching media for chip carrier device as cited in Claim 1, wherein the insulated film can be a plastic film.

6. The switching media for chip carrier device as cited in Claim 1, wherein to construct several containing rooms at the moment of the flexible board being mounted on the carrier base makes that each containing room may then be able to reserve a chip for electrical connection of the flexible board and the chip carrier device, and a way of constructing several containing rooms can be one of the following: folding the flexible board, using plural flexible boards directly.
